# EUROPEAN PATENT APPLICATION

(11) **EP 4 160 784 A1**
(43) Date of publication of application: **05.04.2023**
(21) Application number: 21812723.1
(22) Date of filing: 28.04.2021
(51) Int. Cl.: H01M 10/48, H02J 7/00, G01R 31/367, G01R 31/392

(54) **DETERIORATION ESTIMATION DEVICE, MODEL GENERATION DEVICE, DETERIORATION ESTIMATION METHOD, MODEL GENERATION METHOD, AND PROGRAM**

(30) Priority: 25.05.2020 JP 2020090373
(71) Applicant: Envision AESC Japan Ltd., Zama-shi, Kanagawa 252-0012 (JP)
(72) Inventor: SHIMAWAKI, Hidenori, Zama-shi, Kanagawa 252-0012 (JP); CHEN, Jiuting, Zama-shi, Kanagawa 252-0012 (JP); HAYASHI Itsuro, Zama-shi, Kanagawa 252-0012 (JP)
(74) Representative: Hamer, Christopher K.
(86) International application number: PCT/JP2021/016928
(87) International publication number: WO 2021/241115

(57) **Abstract**

A deterioration estimation apparatus (20) includes a storage processing unit (210) and a calculation unit (240). The storage processing unit (210) acquires a plurality of models from a model generation apparatus (10), and stores the models in a model storage unit (220). A plurality of models are generated by performing machine-learning on training data, the training data using, as input values, measurement data for training indicating a result of measuring a state of a storage battery when the number of charge and discharge times is αᵢ to αⱼ (where j ≥ i), and using, as a target value, SOH indicating a deterioration state of the storage battery when the number of charge and discharge times is β (where β > αⱼ). The calculation unit (240) uses a plurality of models stored in a model storage unit (220) to calculate an estimation result of transition of SOH of a storage battery (30) managed by the deterioration estimation apparatus (20).

## Description

### TECHNICAL FIELD

The present invention relates to a deterioration estimation apparatus, a model generation apparatus, a deterioration estimation method, a model generation method, and a program.

### BACKGROUND ART

In recent years, storage batteries have been used in various places. As a first example, a storage battery is used as a power source of a moving body such as a vehicle. As a second example, a storage battery is used for temporarily storing surplus power.

When a storage battery is used, it is important to accurately calculate a deterioration state (hereinafter referred to as SOH) of the storage battery. For example, Patent Documents 1 describes that an SOH of a storage battery at a second time point, later than a first time point, is estimated by using an SOC and an SOH of the storage battery at the first time point. Further, Patent Document 2 describes that an SOH of a storage battery at a second time point, later than a first time point, is estimated by using an SOH of the storage battery at the first time point and time series data related to a state of the storage battery between the first time point and the second time point.

### RELATED DOCUMENT

### PATENT DOCUMENT

Patent Document 1: International Patent Publication No. WO 2019/181728
Patent Document 2: International Patent Publication No. WO 2019/181729

### SUMMARY OF THE INVENTION

### TECHNICAL PROBLEM

In general, it is possible to estimate current SOH, but it is difficult to estimate future SOH with high accuracy. One example of an object of the present invention is to estimate future SOH of a storage battery with high accuracy.

### SOLUTION TO PROBLEM

According to the present invention, there is provided a deterioration estimation apparatus including:
a storage processing unit that stores, in a storage unit, a plurality of models generated by performing machine-learning on training data, the training data using, as input values, measurement data for training indicating a result of measuring a state of a storage battery when the number of charge and discharge times is αᵢ to αⱼ (where j ≥ i), and using, as a target value, SOH indicating a deterioration state of the storage battery when the number of charge and discharge times is β (where β > αⱼ); and
a calculation unit that acquires measurement data for calculation that is a result of measuring the state when the number of charge and discharge times of a target storage battery to be processed is αᵢ to αⱼ, and inputs the measurement data for calculation into each of the plurality of models to calculate an estimation result of transition of SOH of the target storage battery, in which
αᵢ to αⱼ are the same values in the plurality of models, and β is different in the plurality of models.

According to the present invention, there is provided a deterioration estimation apparatus including:
a storage processing unit that stores, in a storage unit, a plurality of models generated by performing machine-learning on training data, the training data using, as an input value, measurement data for training indicating a result of measuring a state of a storage battery when the number of charge and discharge times is αᵢ, and using, as a target value, SOH indicating a deterioration state of the storage battery when the number of charge and discharge times is β (where β > αᵢ); and
a calculation unit that acquires measurement data for calculation that is a result of measuring the state when the number of charge and discharge times of a target storage battery to be processed is αᵢ, and inputs the measurement data for calculation into the plurality of models to calculate an estimation result of SOH of the target storage battery, in which
αᵢ is the same value in the plurality of models and β is different in the plurality of models.

According to the present invention, there is provided a model generation apparatus including:
a training data acquisition unit that acquires training data prepared for each different β, the training data using, as input values, measurement data for training indicating a result of measuring a state of a storage battery when the number of charge and discharge times is αᵢ to αⱼ (where j ≥ i), and using, as a target value, SOH indicating a deterioration state of the storage battery when the number of charge and discharge times is β (where β > αⱼ); and
a model generation unit that generates, for each of a plurality of βs, a model for calculating an estimated value of SOH of a target storage battery when the number of charge and discharge times is β, from measurement data for calculation indicating the state when the number of charge and discharge times of the target storage battery is αᵢ to αⱼ, by performing machine-learning on the training data for each value of β.

According to the present invention, there is provided a model generation apparatus including:
a training data acquisition unit that acquires training data prepared for each different β, the training data using, as an input value, measurement data for training indicating a result of measuring a state of a storage battery when the number of charge and discharge times is αᵢ, and using, as a target value, SOH indicating a deterioration state of the storage battery when the number of charge and discharge times is β (where β > αᵢ); and
a model generation unit that generates, for each of a plurality of βs, a model for calculating an estimated value of SOH of a target storage battery when the number of charge and discharge times is β, from measurement data for calculation indicating the state when the number of charge and discharge times of the target storage battery is αᵢ, by performing machine-learning on the training data for each value of β.

According to the present invention, there is provided a deterioration estimation method including:
causing a computer to execute:
a storage process of storing, in a storage unit, a plurality of models generated by performing machine-learning on training data, the training data using, as input values, measurement data for training indicating a result of measuring a state of a storage battery when the number of charge and discharge times is αᵢ to αⱼ (where j ≥ i), and using, as a target value, SOH indicating a deterioration state of the storage battery when the number of charge and discharge times is β (where β > αⱼ); and
a calculation process of acquiring measurement data for calculation that is a result of measuring the state when the number of charge and discharge times of a target storage battery to be processed is αᵢ to αⱼ, and inputting the measurement data for calculation into each of the plurality of models to calculate an estimation result of transition of SOH of the target storage battery, in which
αᵢ to αⱼ are the same values in the plurality of models, and β is different in the plurality of models.

According to the present invention, there is provided a deterioration estimation method including:
causing a computer to execute:
a storage process of storing, in a storage unit, a plurality of models generated by performing machine-learning on training data, the training data using, as an input value, measurement data for training indicating a result of measuring a state of a storage battery when the number of charge and discharge times is αᵢ, and using, as a target value, SOH indicating a deterioration state of the storage battery when the number of charge and discharge times is β (where β > αᵢ); and
a calculation process of acquiring measurement data for calculation that is a result of measuring the state when the number of charge and discharge times of a target storage battery to be processed is αᵢ, and inputting the measurement data for calculation into each of the plurality of models to calculate an estimation result of transition of SOH of the target storage battery, in which
αᵢ is the same value in the plurality of models, and β is different in the plurality of models.

According to the present invention, there is provided a model generation method including:
causing a computer to execute:
a training data acquisition process of acquiring training data prepared for each different β, the training data using, as input values, measurement data for training indicating a result of measuring a state of a storage battery when the number of charge and discharge times is αᵢ to αⱼ (where j ≥ i), and using, as a target value, SOH indicating a deterioration state of the storage battery when the number of charge and discharge times is β (where β > αⱼ); and
a model generation process of generating, for each of a plurality of βs, a model for calculating an estimated value of SOH of a target storage battery when the number of charge and discharge times is β, from measurement data for calculation indicating the state when the number of charge and discharge times of the target storage battery is αᵢ to αⱼ, by performing machine-learning on the training data for each value of β.

According to the present invention, there is provided a model generation method including:
causing a computer to execute:
a training data acquisition process of acquiring training data prepared for each different β, the training data using, as an input value, measurement data for training indicating a result of measuring a state of a storage battery when the number of charge and discharge times is αᵢ, and using, as a target value, SOH indicating a deterioration state of the storage battery when the number of charge and discharge times is β (where β > αᵢ); and
a model generation process of generating, for each of a plurality of βs, a model for calculating an estimated value of SOH of a target storage battery when the number of charge and discharge times is β, from measurement data for calculation indicating the state when the number of charge and discharge times of the target storage battery is α*i*, by performing machine-learning on the training data for each value of β.

According to the present invention, there is provided a program providing a computer with:
a storage process function for storing, in a storage unit, a plurality of models generated by performing machine-learning on training data, the training data using, as input values, measurement data for training indicating a result of measuring a state of a storage battery when the number of charge and discharge times is αᵢ to αⱼ (where j ≥ i), and using, as a target value, SOH indicating a deterioration state of the storage battery when the number of charge and discharge times is β (where β > αⱼ); and
a calculation process function for acquiring measurement data for calculation that is a result of measuring the state when the number of charge and discharge times of a target storage battery to be processed is αᵢ to αⱼ, and inputting the measurement data for calculation into each of the plurality of models to calculate an estimation result of transition of SOH of the target storage battery, in which
αᵢ to αⱼ are the same values in the plurality of models, and β is different in the plurality of models.

According to the present invention, there is provided a program providing a computer with:
a storage process function for storing, in a storage unit, a plurality of models generated by performing machine-learning on training data, the training data using, as an input value, measurement data for training indicating a result of measuring a state of a storage battery when the number of charge and discharge times is αᵢ, and using, as a target value, SOH indicating a deterioration state of the storage battery when the number of charge and discharge times is β (where β > αᵢ); and
a calculation process function for acquiring measurement data for calculation that is a result of measuring the state when the number of charge and discharge times of a target storage battery to be processed is αᵢ, and inputting the measurement data for calculation into each of the at least one model to calculate an estimation result of transition of SOH of the target storage battery, in which
αᵢ is the same value in the plurality of models, and β is different in the plurality of models.

According to the present invention, there is provided is a program providing a computer with:
a training data acquisition function for acquiring training data prepared for each different β, the training data using, as input values, measurement data for training indicating a result of measuring a state of a storage battery when the number of charge and discharge times is αᵢ to αⱼ (where j ≥ i), and using, as a target value, SOH indicating a deterioration state of the storage battery when the number of charge and discharge times is β (where β > αⱼ); and
a model generation function for generating, for each of a plurality of βs, a model for calculating an estimated value of SOH of a target storage battery when the number of charge and discharge times is β, from measurement data for calculation indicating the state when the number of charge and discharge times of the target storage battery is αᵢ to αⱼ, by performing machine-learning on the training data for each value of β.

According to the present invention, there is provided a program providing a computer with:
a training data acquisition function for acquiring training data prepared for each different β, the training data using, as an input value, measurement data for training indicating a result of measuring a state of a storage battery when the number of charge and discharge times is αᵢ, and using, as a target value, SOH indicating a deterioration state of the storage battery when the number of charge and discharge times is β (where β > αᵢ); and
a model generation function for generating, for each of a plurality of βs, a model for calculating an estimated value of SOH of a target storage battery when the number of charge and discharge times is β, from measurement data for calculation indicating the state when the number of charge and discharge times of the target storage battery is αᵢ, by performing machine-learning on the training data for each value of β.

### ADVANTAGEOUS EFFECTS OF INVENTION

According to the present invention, the future SOH of a storage battery can be estimated with high accuracy.

### BRIEF DESCRIPTION OF THE DRAWINGS

Fig. 1 is a diagram for explaining a usage environment of a model generation apparatus and a deterioration estimation apparatus according to an example embodiment.
Fig. 2 is a diagram illustrating one example of a functional configuration of the model generation apparatus.
Fig. 3 is a diagram illustrating one example of a functional configuration of the deterioration estimation apparatus.
Fig. 4 is a diagram illustrating an example of a hardware configuration of the model generation apparatus.
Fig. 5 is a flowchart illustrating one example of model generation processing performed by the model generation apparatus.
Fig. 6 is a diagram for explaining a first example of pre-processing (step S30 of Fig. 5) performed by a pre-processing unit of the model generation apparatus.
Fig. 7 is a diagram for explaining a second example of pre-processing (step S30 of Fig. 5) performed by the pre-processing unit of the model generation apparatus.
Fig. 8 is a diagram for explaining the second example of pre-processing (step S30 of Fig. 5) performed by the pre-processing unit of the model generation apparatus.
Fig. 9 is a flowchart illustrating one example of processing for calculating SOH of a storage battery performed by the deterioration estimation apparatus.
Fig. 10 is a diagram for explaining a main part of the processing illustrated in Fig. 9.
Fig. 11 is a diagram illustrating one example of data displayed on a display in step S180.
Fig. 12 is a diagram for explaining one example of data processing according to a modification example.
Fig. 13 is a diagram for explaining one example of data processing according to a modification example.
Fig. 14 is a diagram for explaining one example of data processing according to a modification example.

### DESCRIPTION OF EMBODIMENTS

Hereinafter, an example embodiment of the present invention will be explained by using the drawings. In all the drawings, the same components are denoted by the same reference numerals, and explanation thereof will be omitted as appropriate.

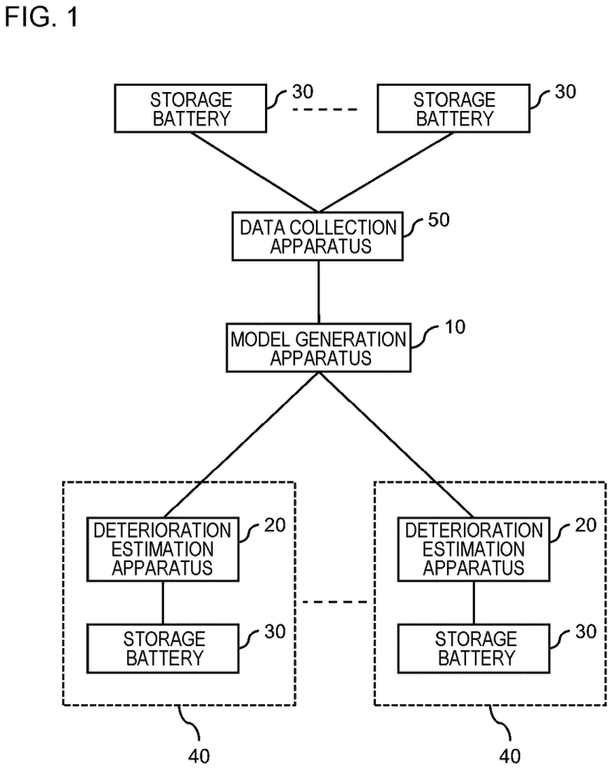

Fig. 1 is a diagram for explaining a usage environment of a model generation apparatus 10 and a deterioration estimation apparatus 20 according to an example embodiment. The model generation apparatus 10 and the deterioration estimation apparatus 20 are used together with a storage battery 30. The deterioration estimation apparatus 20 may be a Battery Management System (BMS) of the storage battery 30, or may be an apparatus different from the BMS of the storage battery 30.

The storage battery 30 supplies electric power to an equipment 40. In the example illustrated in this figure, the deterioration estimation apparatus 20 and the storage battery 30 are provided in the equipment 40. As one example, the equipment 40 is a vehicle such as an electric vehicle. However, when the storage battery 30 is a household storage battery, the equipment 40 is electric equipment used in the household. In this case, the storage battery 30 is located outside the equipment 40. Further, the storage battery 30 may be connected to a power grid network. In this case, the storage battery 30 is used for equalizing supplied power. Specifically, the equipment 40 stores electric power when the electric power is remaining, and supplies electric power when the electric power is unexpected.

The deterioration estimation apparatus 20 estimates a deterioration state, that is, a state of health (SOH) of the storage battery 30 by using a model. The model generation apparatus 10 generates and updates at least one model used by the deterioration estimation apparatus 20, by using machine learning, for example, a neural network. The SOH is, for example, "current full charge capacity (Ah)/initial full charge capacity (Ah)×100(%)".

The model generation apparatus 10 acquires measured values (hereinafter, referred to as actual result data) of data related to a state of the storage battery 30 from a plurality of storage batteries 30. A part of the plurality of pieces of actual result data is used as training data for machine learning, and at least a part of the remaining actual result data is used for verifying the model.

The actual result data include at least results of measuring transition of a state of the storage battery 30 during charging and discharging when the number of charge and discharge times of the storage battery 30 is αᵢ to αⱼ (where j ≥ i) (hereinafter referred to as measurement data), and SOH when the number of charge and discharge times of the storage battery 30 is β (where β > αj). The measurement data include, for example, a current, a voltage and temperature. Herein, the actual result data may include SOH at different βs from each other for one piece of measurement data. In other words, the actual result data indicate measurement data such as current, voltage, and temperature at a certain number of charge and discharge times, and transition of SOH at the subsequent numbers of charge and discharge times. As one example, one piece of actual result data includes measurement data when the number of charge and discharge times is αᵢ to αⱼ (for example, 1 ≤ αᵢ ≤ 10 and 1 < αⱼ ≤ 100), and SOH measured at each of β₁, β₂, ..., βₖ (for example, 200, 300, ...) after the number of charge and discharge times αⱼ.

In addition, it is preferable that the actual result data include information determining a type (e.g., a product name or a model number) of the storage battery 30. In this way, the model generation apparatus 10 can generate a model for each type of the storage battery 30. The deterioration estimation apparatus 20 can acquire a model being associated to the type of the storage battery 30 to which the deterioration estimation apparatus 20 is connected, from the model generation apparatus 10 and use the model. Therefore, estimation accuracy of SOH of the storage battery 30 by the deterioration estimation apparatus 20 is increased.

At least a part of the actual result data is acquired from a data collection apparatus 50. The data collection apparatus 50 is an apparatus that collects actual result data, and acquires actual result data from each of the plurality of storage batteries 30. The storage batteries 30 managed by the data collection apparatus 50 are used mainly for the purpose of collecting actual result data. Note that the actual result data may be further acquired from the deterioration estimation apparatus 20.

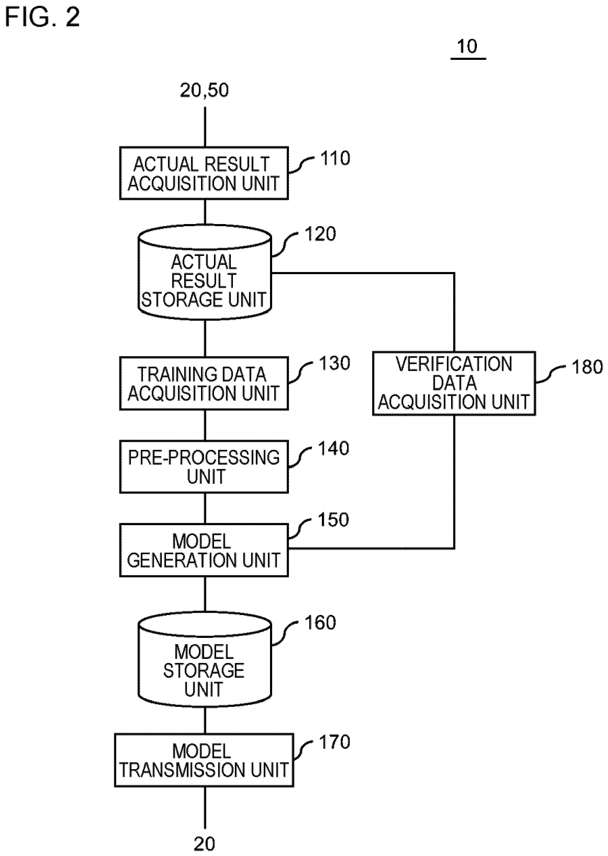

Fig. 2 is a diagram illustrating one example of a functional configuration of the model generation apparatus 10. In the example illustrated in the figure, the model generation apparatus 10 includes a training data acquisition unit 130 and a model generation unit 150. The training data acquisition unit 130 acquires a plurality of pieces of training data. As one example, each piece of the training data has measurement data for training including a current, a voltage, and a temperature in a certain charge and discharge cycle of a storage battery as input values, and has SOH for training which is SOH of the storage battery as a target value. The model generation unit 150 generates a model by performing machine learning on the plurality of pieces of training data. This model calculates SOH of an object storage battery from measurement data for calculation including a current, a voltage, and a temperature of the object storage battery, the object storage battery being an object of processing.

Here, the training data acquisition unit 130 acquires training data for each combination of αᵢ to αⱼ and β. In other words, αᵢ to αⱼ and β are the same for each of data configuring a certain training data. The model generation unit 150 generates a model for each β described above. That is, the training data acquisition unit 130 generates a plurality of models. Each of the plurality of models is generated by performing machine-learning on training data, the training data including measurement data for training which is measurement data of the storage battery when the number of charge and discharge times is αᵢ to αⱼ as input values and SOH indicating a deterioration state of the storage battery when the number of charge and discharge times is β (where β > αⱼ) as a target value. Here, αᵢ to αⱼ are the same values in the plurality of models, and β is different for each of the plurality of models. Each of the plurality of models calculates an estimation value of SOH of the storage battery 30 when the number of charge and discharge times is β, from the measurement data for calculation indicating a state of the storage battery 30 when the number of charge and discharge times of the storage battery 30 is αᵢ to αⱼ. For example, when there are k βs (β₁, β₂, ..., βₖ), k models are generated.

Here, the model generation unit 150 may generate a plurality of models for each β by using a plurality of machine-learning algorithms (for example, Long Short-Term Memory (LSTM), Deep Neural Network (DNN), Linear Regression (LR), or the like). In this case, the deterioration estimation apparatus 20 also uses the plurality of models. Further, the model generation unit 150 may use, as to at least one β, a different machine-learning algorithm from other βs. In other words, the model generation unit 150 may generate a model for each β by using a machine-learning algorithm that is optimal for the β.

Note that the measurement data for training may be only a current, a voltage, and a temperature. In this case, the measurement data for calculation being input to the model are also only the current, the voltage, and the temperature.

The model generation apparatus 10 further includes a pre-processing unit 140. When the type of data (parameters) included in the measurement data for training is m (e.g., m=3 in a case of only current, voltage, and temperature), the pre-processing unit 140 works n sets of measurement data for training into a matrix of ((aⱼ-aᵢ+1)×m)×n, and processes the matrix, thereby generating one-dimensional data consisting of z pieces of data. The model generation unit 150 generates a model by using the one-dimensional data as an input value. The pre-processing unit 140 uses a digital filter when generating a one-dimensional model. A detailed example of this processing will be described later.

The plurality of models generated by the model generation unit 150 are stored in a model storage unit 160. Then, the plurality of models stored in the model storage unit 160 are transmitted to the deterioration estimation apparatus 20 by a model transmission unit 170. In the example illustrated in the figure, the model storage unit 160 and the model transmission unit 170 are part of the model generation apparatus 10. However, at least one of the model storage unit 160 and the model transmission unit 170 may be an external apparatus of the model generation apparatus 10.

In the example illustrated in the figure, the model generation apparatus 10 further includes an actual result acquisition unit 110, an actual result storage unit 120, a training data acquisition unit 130, and a verification data acquisition unit 180.

The actual result acquisition unit 110 acquires the above-described actual result data from at least one of the deterioration estimation apparatus 20 and the data collection apparatus 50, and stores the actual result data in the actual result storage unit 120. Herein, the actual result acquisition unit 110 stores the actual result data in association with information determining an acquisition source of the actual result data. In addition, the actual result acquisition unit 110 may store the actual result data in association with information indicating the type of the storage battery 30 that is an object of measurement of the actual result data.

As described above, a part of the plurality of actual result data is used as the training data described above, and at least a part of the remaining actual result data is used for verifying the model. Therefore, the actual result storage unit 120 stores each of the plurality of actual result data in association with information indicating whether the piece of actual result data is used as training data. This association may be performed in accordance with an input from a user, or may be performed by the actual result acquisition unit 110.

Then, the training data acquisition unit 130 reads the data being used as the training data out of the actual result data from the actual result data storage unit 120. When the model generation unit 150 generates a model for each type of the storage battery 30, the training data acquisition unit 130 reads the training data for each type of the model.

In addition, the verification data acquisition unit 180 reads out at least a part of the data that are not used as the training data out of the actual result data in order to verify the model generated by the model generation unit 150. This verification of the model is performed by the model generation unit 150.

Since the actual result acquisition unit 110 operates periodically, the actual result data stored in the actual result storage unit 120 are periodically updated (added). Then, the model generation unit 150 periodically updates the model. When the model stored in the model storage unit 160 is updated, the model transmission unit 170 transmits data for updating the model to the deterioration estimation apparatus 20.

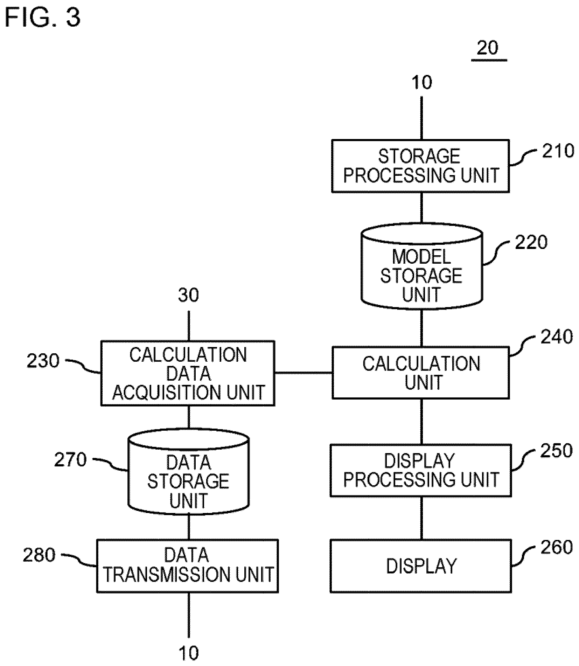

Fig. 3 is a diagram illustrating one example of a functional configuration of the deterioration estimation apparatus 20. The deterioration estimation apparatus 20 includes a storage processing unit 210 and a calculation unit 240.

The storage processing unit 210 acquires a plurality of models from the model generation apparatus 10 and stores the plurality of models in a model storage unit 220. When the data for updating the model are acquired from the model generation apparatus 10, the storage processing unit 210 uses this data so as to update the model stored in the model storage unit 220. The update processing is preferably repeated. In the example illustrated in this figure, the model storage unit 220 is a part of the deterioration estimation apparatus 20. However, the model storage unit 220 may be an external apparatus of the deterioration estimation apparatus 20.

The calculation unit 240 calculates an estimation result of transition of SOH of the storage battery 30 being managed by the deterioration estimation apparatus 20, by using the plurality of models stored in the model storage unit 220. At this time, data being input to the model (hereinafter referred to as measurement data for calculation) is measurement data when the number of charge and discharge times of the storage battery 30 is αᵢ to αⱼ. This measurement data includes, for example, a current, a voltage, and a temperature. For example, when the input data at a time of generating the model are only a current, a voltage, and a temperature, the measurement data for calculation are only the current, the voltage, and the temperature.

In the present example embodiment, the deterioration estimation apparatus 20 includes a display processing unit 250. The display processing unit 250 causes a display 260 to display SOH of the storage battery 30 that has been calculated by the calculation unit 240. The display 260 is disposed at a position visible to a user of the equipment 40. For example, when the equipment 40 is a vehicle, the display 260 is provided inside the vehicle (e.g., in front of a driver's seat or obliquely in front of the driver's seat).

In the example illustrated in the figure, the deterioration estimation apparatus 20 further includes a calculation data acquisition unit 230, a data storage unit 270, and a data transmission unit 280.

The calculation data acquisition unit 230 acquires measurement data for calculation from the storage battery 30. The data storage unit 270 stores data acquired by the calculation data acquisition unit 230 together with the number of charge and discharge times at that time (that is, from α*i* to αⱼ as described above). Thereafter, the calculation data acquisition unit 230 also stores data (for example, SOH itself may be used) for determining SOH when the number of charge and discharge times reaches a predetermined value (β₁, β₂, ..., βₖ as described above). The data transmission unit 280 transmits at least a part of the measurement data for calculation to the model generation apparatus 10 together with data for determining SOH, as described above, of the storage battery 30. The data are treated as actual result data.

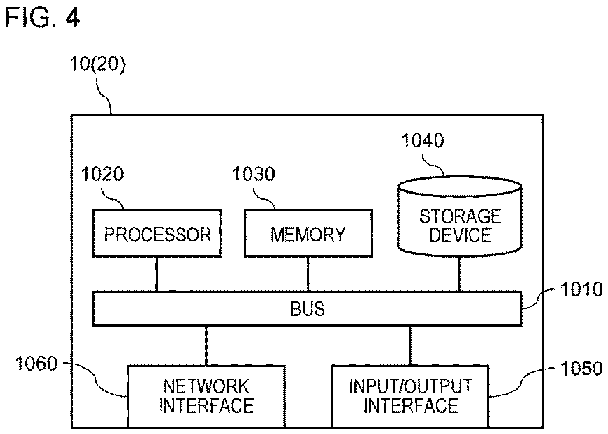

Fig. 4 is a diagram illustrating an example of a hardware configuration of the model generation apparatus 10. The model generation apparatus 10 includes a bus 1010, a processor 1020, a memory 1030, a storage device 1040, an input/output interface 1050, and a network interface 1060.

The bus 1010 is a data transmission path through which the processor 1020, the memory 1030, the storage device 1040, the input/output interface 1050, and the network interface 1060 transmit and receive data to and from each other. However, a method of connecting the processor 1020 and the like to each other is not limited to bus connection.

The processor 1020 is a processor achieved by a Central Processing Unit (CPU), a Graphics Processing Unit (GPU), or the like.

The memory 1030 is a main storage achieved by a Random Access Memory (RAM) or the like.

The storage device 1040 is an auxiliary storage achieved by a Hard Disk Drive (HDD), a Solid State Drive (SSD), a memory card, a Read Only Memory (ROM), or the like. The storage device 1040 stores a program module that achieves each function of the model generation apparatus 10 (e.g., the actual result acquisition unit 110, the training data acquisition unit 130, the pre-processing unit 140, the model generation unit 150, the model transmission unit 170, and the verification data acquisition unit 180). When the processor 1020 reads and executes the program modules on the memory 1030, each function being associated to the program module is achieved. The storage apparatus 1040 also functions as the actual result storage unit 120 and the model storage unit 160.

The input/output interface 1050 is an interface for connecting the model generation apparatus 10 and various kinds of input/output equipment.

The network interface 1060 is an interface for connecting the model generation apparatus 10 to a network. The network is, for example, a Local Area Network (LAN) or a Wide Area Network (WAN). The method by which the network interface 1060 connects to the network may be a wireless connection or a wired connection. The model generation apparatus 10 may communicate with the deterioration estimation apparatus 20 and the data collection apparatus 50 via the network interface 1060.

The hardware configuration of the deterioration estimation apparatus 20 is also similar to the example illustrated in Fig. 4. The storage device stores a program module that achieves each function of the deterioration estimation apparatus 20 (e.g., the storage processing unit 210, the calculation data acquisition unit 230, the calculation unit 240, the display 260, and the data transmission unit 280). The storage device also functions as the model storage unit 220 and the data storage unit 270.

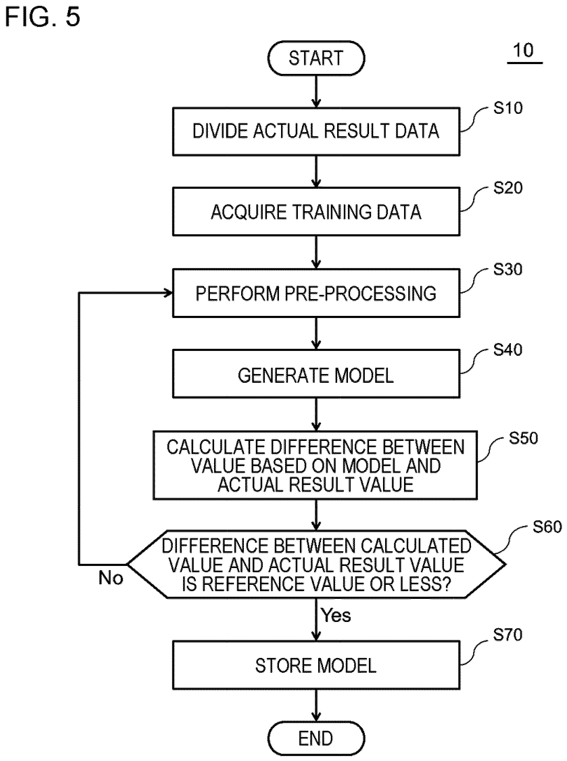

Fig. 5 is a flowchart illustrating one example of a model generation processing performed by the model generation apparatus 10. Apart from the processing illustrated in this figure, the actual result acquisition unit 110 repeatedly acquires the actual result data and updates the actual result storage unit 120.

First, the actual result data are classified into training data and other data (step S10). Then, the training data acquisition unit 130 of the model generation apparatus 10 reads the training data from the actual result storage unit 120 (step S20). Next, the pre-processing unit 140 performs pre-processing on the training data, and converts the measurement data for training (i.e., input data) included in the training data into one-dimensional data. At this time, a digital filter (described later) is used (step S30). A detailed example of step S30 will be explained by using other figures.

Then, the model generation unit 150 generates a model by using the training data after having been converted in step S30 (Step S40).

Thereafter, the model generation unit 150 reads, from the actual result storage unit 120, data that are not used as training data out of the actual result data, and verifies the accuracy of the model calculated in step S40 by using this data. Specifically, the model generation unit 150 inputs data including a current, a voltage, and a temperature to the generated model, and acquires an estimation result of SOH. Then, a difference between the estimation result and an actual result value of SOH read out from the actual result storage unit 120 is calculated (step S50). When the difference (that is, an error) is equal to or less than a reference value (step S60: Yes), the model generation unit 150 stores the generated model in the model storage unit 160 (step S70).

On the other hand, when the difference calculated in step S50 is greater than the reference value (step S60: No), the processing from step S30 onward are repeated. At this time, the pre-processing unit 140 changes a value of the digital filter to be used in the pre-processing as necessary. When the model is a neural network, the model generation unit 150 optimizes coefficients between neurons of the neural network as necessary. These two processing may be performed each time or only one of them may be performed.

Herein, when the value of the digital filter to be used in the pre-processing is changed, the model generation unit 150 also stores the changed value of the digital filter in the model storage unit 160. Then, the model transmission unit 170 transmits this value of the digital filter to the deterioration estimation apparatus 20. The storage processing unit 210 of the deterioration estimation apparatus 20 also stores the value of the digital filter together with the model, in the model storage unit 220. Thus, the calculation unit 240 of the deterioration estimation apparatus 20 can perform the same conversion processing as in step S30. One example of the timing at which the value of the digital filter is transmitted is when the model is transmitted to the deterioration estimation apparatus 20.

As explained by using Fig. 2, the model generation unit 150 may generate a plurality of models for one β by using a plurality of machine-learning algorithms. In this case, the model generation unit 150 performs the processing of steps S30 to S60, for each of the plurality of machine-learning algorithms. Then, the model generation unit 150 stores the plurality of models in the model storage unit 160 in step S70.

Further, as explained by using Fig. 2, the model generation unit 150 may generate a model for each β by using a machine-learning algorithm that is optimal for the β. In this case, the processing of steps S30 to S60 is performed for each of the plurality of machine-learning algorithms. Then, in step S70, the model generation unit 150 stores the model with the smallest error calculated in step S60, that is, the model with the highest accuracy, in the model storage unit 160.

The model generation apparatus performs the processing illustrated in Fig. 5 for each β described above. Further, when a model is generated for each type of the storage battery 30, the model generation apparatus 10 performs the processing illustrated in Fig. 5 for each type and for each β described above.

Further, the model generation apparatus 10 may perform the above-described processing for a plurality of combinations of αᵢ and αⱼ. In this case, the model generation apparatus 10 generates the above-described model, for each of a plurality of different combinations of αᵢ and αⱼ.

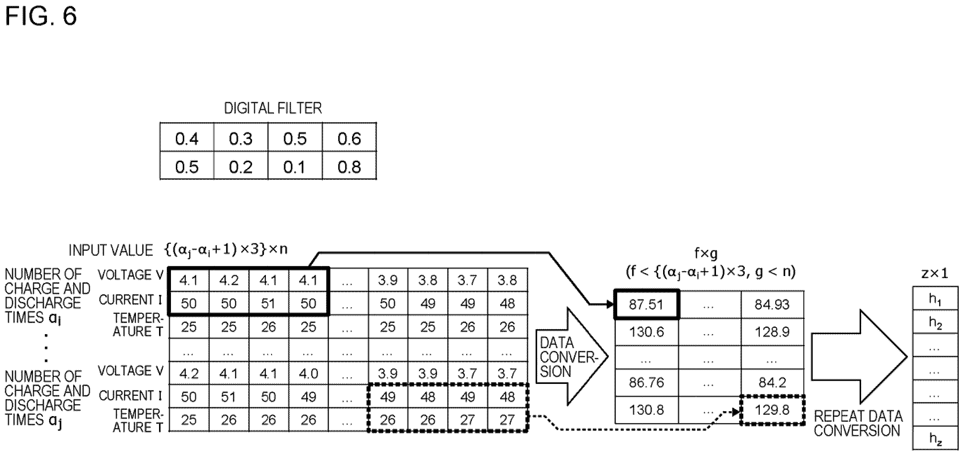

Fig. 6 is a diagram for explaining a first example of pre-processing (step S30 in Fig. 5) performed by the pre-processing unit 140 of the model generation apparatus 10. As explained by using Fig. 2, the pre-processing unit 140 works n sets of measurement data for training obtained for each of αᵢ and αⱼ into matrices of ((αⱼ-αᵢ+1)×m)×n and processes the matrices, thereby generating one-dimensional data consisting of z pieces of data. Herein, m is the number of types of data (parameters) included in the measurement data for training.

In the example illustrated in this figure, the pre-processing unit 140 processes digital filter on the matrix, thereby performing, at least once, conversion processing of reducing a number of dimensions. As a result, one-dimensional data to be input data are generated.

More specifically, the digital filter is a matrix. The pre-processing unit 140 performs the following (1) and (2) at least once as the conversion processing.
(1) A partial matrix consisting of the same number of rows and the same number of columns as the digital filter is extracted from a matrix being an object of processing.
(2) A digital filter is operated on the partial matrix, and a value acquired by adding each element of the operation result is set as an element of the matrix after processing. The operation performed here is, for example, multiplication, but may be addition, subtraction, or division, or may be a combination of four arithmetic operations as appropriate. Note that the position of the element of the matrix after processing is associated to the position where the partial matrix is cut out. For example, the value calculated by using the most upper-left partial matrix becomes the element, in the first row and first column, of the matrix after processing. Further, a value calculated by using the most lower-right partial matrix becomes the element, which is the most lower-right, of the matrix after processing.

In the example illustrated in this figure, the pre-processing unit 140 may perform processing of expanding at least one of the rows and the columns of the matrix by adding a dummy value to the outer periphery of the matrix before (1). For example, a row having a dummy value may be added above the first row, a row having a dummy value may be added further below the lowermost row of the object row, and a row having a dummy value may be added further at a boundary between a certain number of charge and discharge times and the next. The dummy values added here are all the same values (e.g., 0). However, this processing may not be performed.

When the above-described conversion processing is repeated, it is not necessary to use the same digital filter in each conversion processing. Since each of these digital filters is optimized, these digital filters are mostly different from each other.

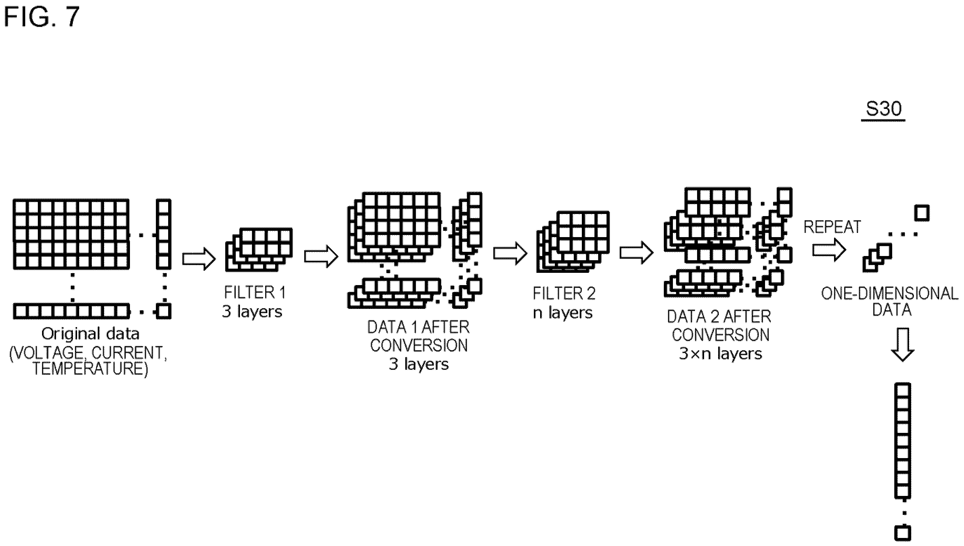

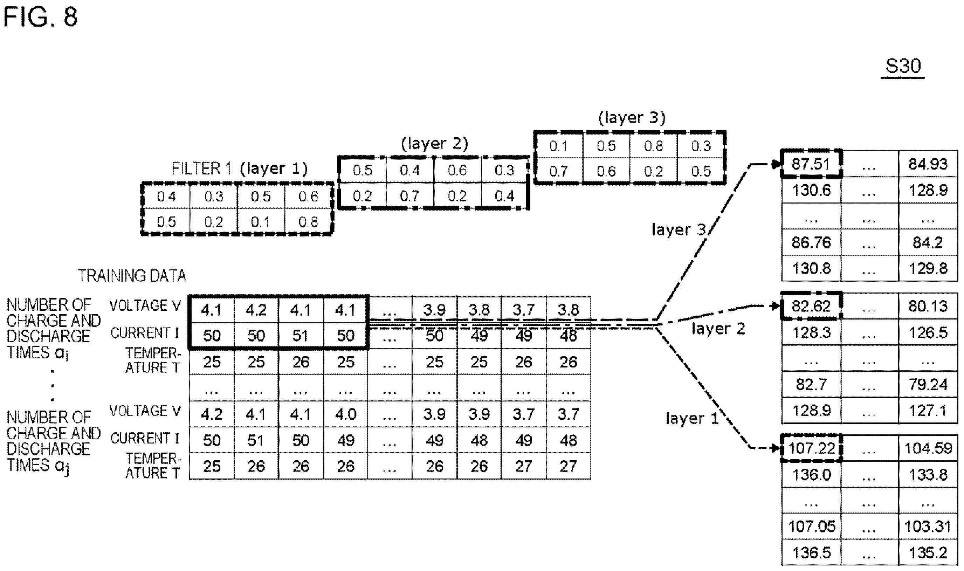

Figs. 7 and 8 are diagrams for explaining a second example of the pre-processing (step S30 in Fig. 5) performed by the pre-processing unit 140 of the model generation apparatus 10. In this example, as illustrated in Fig. 8, the pre-processing unit 140 prepares a plurality of digital filters for a single conversion processing, and generates a matrix after conversion for each of the plurality of digital filters. For example, when three digital filters are used in certain conversion processing, the number of matrices after conversion is three times the number of matrices before conversion.

Then, as illustrated in Fig. 7, when the pre-processing unit 140 repeats this processing, at any stage, the plurality of matrices after conversion are all in one row and one column. Then, the pre-processing unit 140 generates one-dimensional data to be input data by arranging the data of one row and one column.

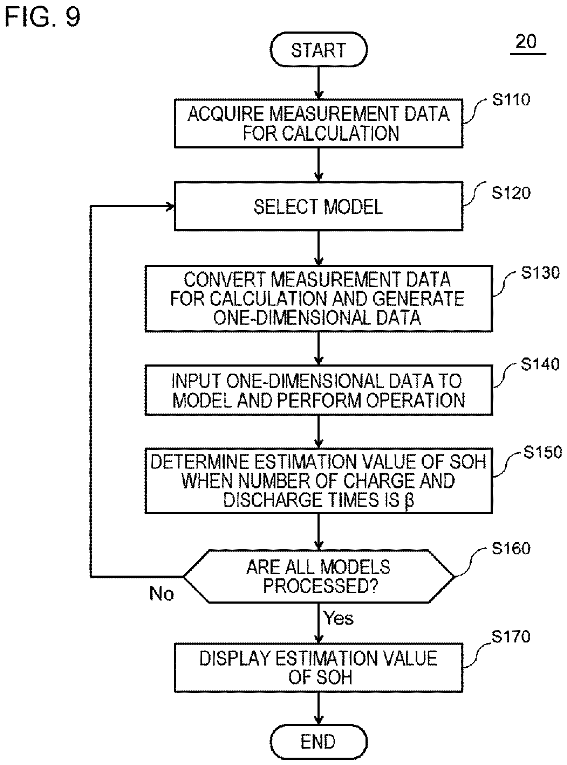

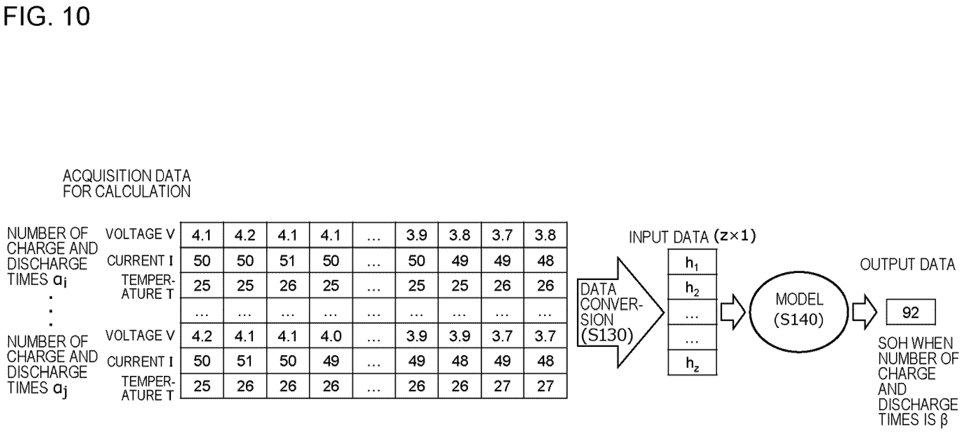

Fig. 9 is a flowchart illustrating one example of calculation processing of SOH of the storage battery 30, which is performed by the deterioration estimation apparatus 20. Fig. 10 is a diagram for explaining a main part of the processing illustrated in Fig. 9. The storage battery 30 generates measurement data for calculation at least each time the storage battery 30 repeats charging and discharging, for example. The deterioration estimation apparatus 20 performs the processing illustrated in this figure when the number of charge and discharge times reaches αⱼ. When the model generation apparatus 10 generates the above-described model for each of the plurality of different combinations of αᵢ and αⱼ, the model generation apparatus 10 performs the process illustrated in this figure each time the number of charge and discharge times reaches αⱼ.

First, the calculation data acquisition unit 230 of the deterioration estimation apparatus 20 acquires the measurement data for calculation from the storage battery 30 (step S110 in Fig. 9). Further, the calculation unit 240 reads a plurality of models from the model storage unit 240. The calculation unit 240 then uses the plurality of models to calculate estimation values of SOH when the number of charge and discharge times reaches each of β₁, β₂, ..., βₖ.

Specifically, the calculation unit 240 selects a model which that has not yet been processed (step S120 in Fig. 9). Then, the calculation unit 240 generates converted data by performing the same conversion processing as the pre-processing performed by the pre-processing unit 140 of the model generation apparatus 10 on the measurement data for calculation (step S130 in Fig. 9).

As one example, as illustrated in Fig. 10, the measurement data for calculation are a matrix of ((αⱼ-αᵢ+1)×m)×n (m=3 in the example of Fig. 10). Then, the calculation unit 240 performs the same processing as the pre-processing of the training target data on the measurement data for calculation after expansion, thereby generating one-dimensional data consisting of z pieces of data. At this time, the calculation unit 240 reads the value of the digital filter from the model storage unit 220 and uses the value (step S130).

Next, the calculation unit 240 inputs the one-dimensional data to the model stored in the model storage unit 220 and acquires output data. As illustrated in Fig. 10, the output data have the same data structure (1×1 matrix in the example illustrated in this figure) as the target value of the training data used when the model is generated (step S140). Then, the calculation unit 240 sets the output data, as an estimation value of SOH when the number of charge and discharge times reaches β (step S150).

The calculation unit 240 performs the processing of steps S130 to S160 for each of the plurality of models (for each of the plurality of β) (step S160). Thereafter, the display processing unit 250 displays the calculated estimation result of transition of SOH on the display 260 (step S170).

Note that the model storage unit 220 may store a plurality of models generated using a plurality of machine-learning algorithms, for each combination of β and one of αᵢ to αⱼ. In this case, the calculation unit 240 performs the processing of steps S130 to S160 for each of these models. Therefore, the calculation unit 240 calculates the estimation value of SOH for each model. Then, the calculation unit 240 uses an average value or weighted average value of these plurality of estimation values as an estimation value of SOH for the combination of αᵢ to αⱼ and β.

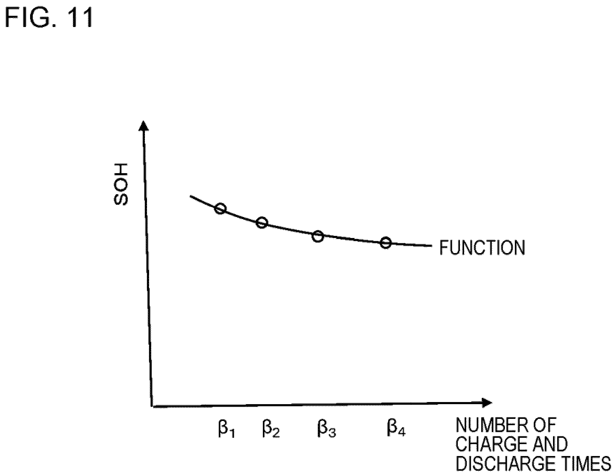

Fig. 11 is a diagram illustrating an example of data displayed on the display 260 in step S180. As described above, the model is used, by the calculation unit 240, to calculate an estimation value of SOH of the storage battery 30 when the number of charge and discharge times reaches β. In the example illustrated in this figure, there are four models, and these four models have different βs (β1, β2, β3, and β4). In other words, these four models are optimized such that SOH can be calculated with high accuracy at the number of charge and discharge times (β) assigned to each model. Therefore, an estimation value of SOH at each of β1, β2, β3, and β4 has high accuracy.

Note that, as illustrated in Fig. 11, the calculation unit 240 may define a function for calculating an estimation value of SOH from the number of charge and discharge times, by using a calculated value of each of a plurality of models.

As described above, according to the present example embodiment, the deterioration estimation apparatus 20 calculates SOH of the storage battery 30, by using the plurality of models generated by the model generation apparatus 10. The plurality of models, used by the calculation unit 240, calculate estimation values of SOH of the storage battery 30 when the number of charge and discharge times reaches β. Here, the plurality of models have different βs. That is, the plurality of models are optimized such that SOH can be calculated with high accuracy at the number of charge and discharge times (β) assigned to each model. Therefore, it is possible to accurately calculate the estimation values of SOH for a plurality of numbers of charge and discharge times.

Further, the model generation apparatus 10 can generate a model when there are a current, a voltage, and a temperature of the storage battery 30 as input values of the training data. Therefore, the number of parameters of the storage battery 30 required when the deterioration estimation apparatus 20 calculates SOH of the storage battery 30 can be set to three (current, voltage, and temperature) at minimum. Therefore, in a case of estimating SOH of the storage battery 30 by using machine learning, the calculation amount required for the deterioration estimation apparatus 20 is reduced.

Note that the model generation apparatus 10 may have the functions of the deterioration estimation apparatus 20. In this case, an estimation value of SOH can be provided to a customer, for example, by a cloud service.

### (Modification example)

In the above embodiment, measurement data for training and measurement data for calculation are data obtained at each of the number of charge and discharge times of αᵢ to αⱼ. On the other hand, in the present modification example, both measurement data training and measurement data for calculation are data when the number of charge and discharge times is αi. According to the present modification example, the deterioration estimation apparatus can update the estimation result of deterioration each time the number of charge and discharge times increases by one.

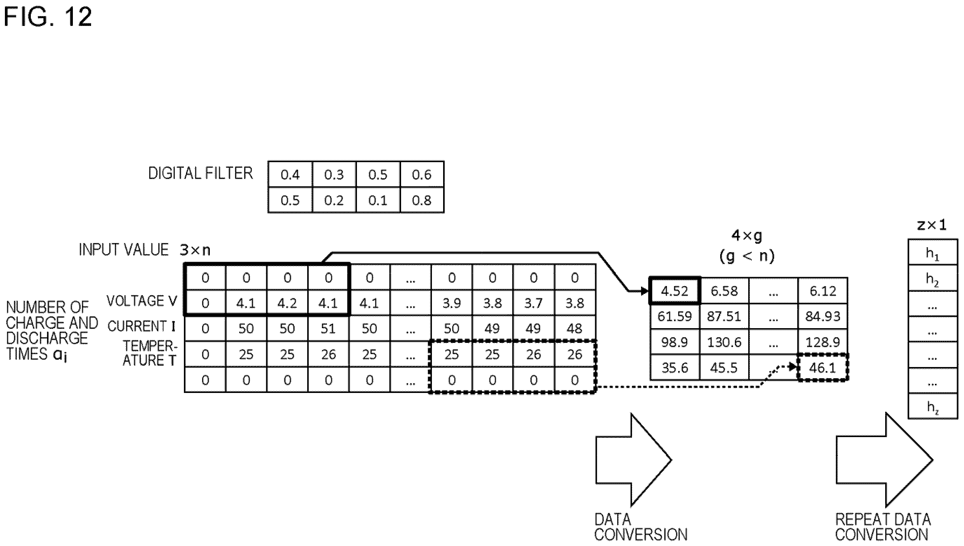

Figs. 12 to 14 are diagrams for explaining an example of a data process according to the present modification example. Figs. 12, 13, and 14 respectively correspond to Figs. 6, 8, and 10 of the embodiment.

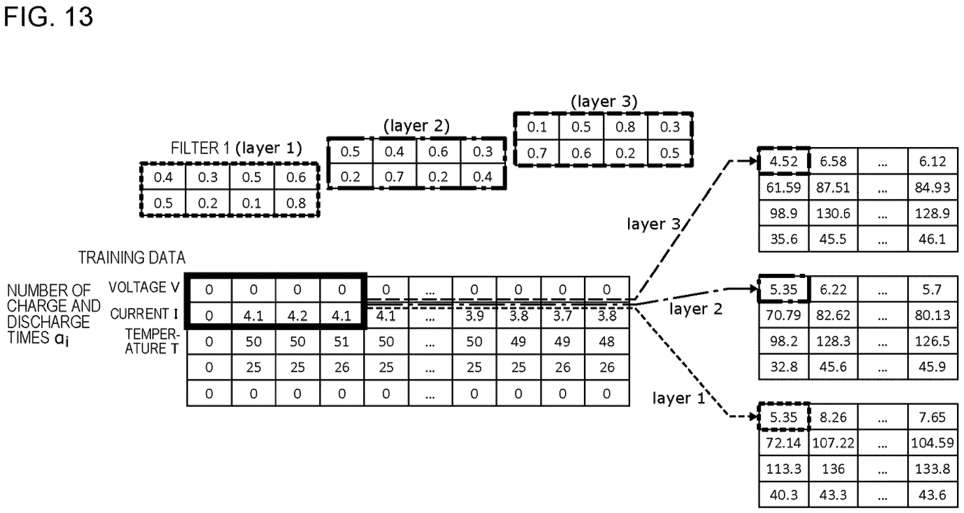

As illustrated in Figs. 12 and 13, in the present modification example, the pre-processing unit 140 of the model generation apparatus 10 performs processing of expanding at least one of the rows and the columns of a matrix including the measurement data for training by adding dummy data to the outer periphery of the matrix before (1) that described with reference to Fig.6. In the example illustrated in this figure, a row having dummy data is added above the first row, a row having dummy data is added further below the lowermost row of the object rows, and a column having dummy data is added further to a left side of the leftmost column. The dummy values added here are all the same values (e.g., 0).

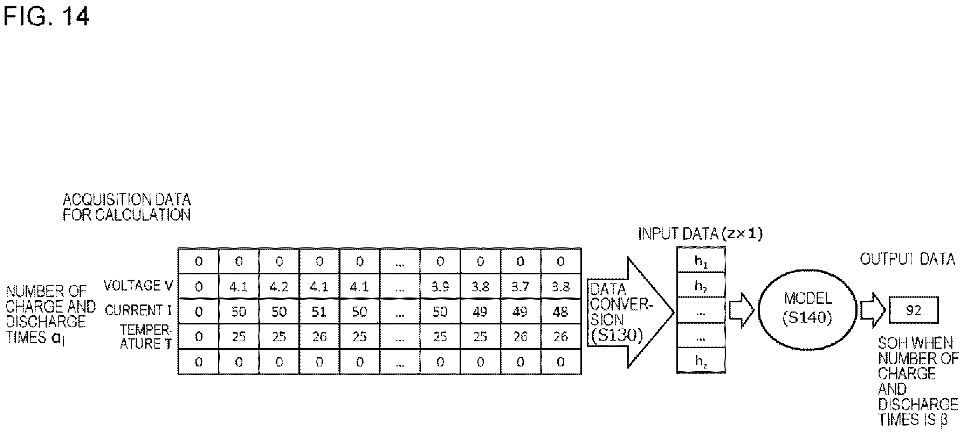

Then, as illustrated in Fig. 14, the calculation unit 240 of the deterioration estimation apparatus 20 also performs processing of calculating an estimation value of SOH, after adding dummy data to the outer periphery of the matrix including the measurement data for calculation.

By using dummy data as illustrated in these figures, even when the number of training data is one (that is, a set of data obtained from a single charge and discharge cycle), it is possible to perform deterioration estimation with high accuracy.

In addition, in the present modification example, it is conceivable that the deterioration estimation apparatus 20 may calculate an estimation value of SOH at a certain β. In this case, the model generation apparatus 10 may generate a plurality of models having the same β and different αᵢ. When the deterioration estimation apparatus 20 uses the plurality of models, each time the number of charge and discharge times of the storage battery 30 increases (that is, each time αᵢ increases), the deterioration estimation apparatus 20 can update the estimation value of SOH of the storage battery 30 when the number of charge and discharge times reaches β.

Although the example embodiments of the present invention have been described above with reference to the drawings, these are examples of the present invention, and various configurations other than the above can also be adopted.

Further, in the plurality of flowcharts used in the above-described explanation, a plurality of steps (processes) are described in order, but an execution order of the steps executed in each example embodiment is not limited to the order described. In each of the example embodiments, the order of the steps illustrated can be changed within a range that does not interfere with the contents. Further, the above-described example embodiments can be combined within a range in which the contents do not conflict with each other.

This application claims priority based on Japanese Patent Application No. 2020-090373 filed on May 25, 2020, the disclosure of which is incorporated herein in its entirety.

### REFERENCE SIGNS LIST

10 Model generation apparatus
20 Deterioration estimation apparatus
30 Storage battery
40 Equipment
50 Data collection apparatus
110 Actual result acquisition unit
120 Actual result storage unit
130 Training data acquisition unit
140 Pre-processing unit
150 Model generation unit
160 Model storage unit
170 Model transmission unit
180 Verification data acquisition unit
210 Storage processing unit
220 Model storage unit
230 Calculation data acquisition unit
240 Calculation unit
250 Display processing unit
260 Display
270 Data storage unit
280 Data transmission unit

## Claims

1. A deterioration estimation apparatus comprising:
a storage processing unit that stores, in a storage unit, a plurality of models generated by performing machine-learning on training data, the training data using, as input values, measurement data for training indicating a result of measuring a state of a storage battery when the number of charge and discharge times is αᵢ to αⱼ (where j ≥ i), and using, as a target value, SOH indicating a deterioration state of the storage battery when the number of charge and discharge times is β (where β > αⱼ); and
a calculation unit that acquires measurement data for calculation that is a result of measuring the state when the number of charge and discharge times of a target storage battery to be processed is αᵢ to αⱼ, and inputs the measurement data for calculation into each of the plurality of models to calculate an estimation result of transition of SOH of the target storage battery, wherein
αᵢ and αⱼ are the same values in the plurality of models, and β is different in the plurality of models.

2. The deterioration estimation apparatus according to claim 1, wherein
the measurement data for training and the measurement data for calculation each includes current, voltage, and temperature.

3. The deterioration estimation apparatus according to claim 2, wherein
the measurement data for training and the measurement data for calculation each consists of current, voltage, and temperature.

4. The deterioration estimation apparatus according to any one of claims 1 to 3, wherein
the model is generated using the training data relating to a plurality of the storage batteries.

5. The deterioration estimation apparatus according to any one of claims 1 to 4, wherein
the storage processing unit acquires data for updating at least one of the models from an external device, and uses the data to update the models stored in the storage unit.

6. The deterioration estimation apparatus according to claim 5, further comprising:
a data transmission unit that transmits the measurement data for calculation when the number of charge and discharge times of the target storage battery is αᵢ to αⱼ, and data for determining SOH when the number of charge and discharge times of the target storage battery is β, as the training data, to the external device.

7. A deterioration estimation apparatus comprising:
a storage processing unit that stores, in a storage unit, a plurality of models generated by performing machine-learning on training data, the training data using, as an input value, measurement data for training indicating a result of measuring a state of a storage battery when the number of charge and discharge times is αᵢ, and using, as a target value, SOH indicating a deterioration state of the storage battery when the number of charge and discharge times is β (where β > αᵢ); and
a calculation unit that acquires measurement data for calculation that is a result of measuring the state when the number of charge and discharge times of a target storage battery to be processed is αᵢ, and inputs the measurement data for calculation into each of the plurality of models to calculate an estimation result of transition of SOH of the target storage battery, wherein
αᵢ is the same value in the plurality of models, and β is different in the plurality of models.

8. A model generation apparatus comprising:
a training data acquisition unit that acquires training data prepared for each different β, the training data using, as input values, measurement data for training indicating a result of measuring a state of a storage battery when the number of charge and discharge times is αᵢ to αⱼ (where j ≥ i), and using, as a target value, SOH indicating a deterioration state of the storage battery when the number of charge and discharge times is β (where β > αⱼ); and
a model generation unit that generates, for each of a plurality of βs, a model for calculating an estimated value of SOH of a target storage battery when the number of charge and discharge times is β, from measurement data for calculation indicating the state when the number of charge and discharge times of the target storage battery is αᵢ to αⱼ, by performing machine-learning on the training data for each value of β.

9. The model generation apparatus according to claim 8, wherein
the model generation unit, in at least one β, generates a plurality of the models by using a plurality of machine-learning algorithms.

10. The model generation apparatus according to claim 8 or 9, wherein
the model generation unit uses, in at least one β, a different machine-learning algorithm from other βs.

11. The model generation apparatus according to any one of claims 8 to 10, wherein
the training data is prepared for each type of the storage battery, and
the model generation unit generates the model for each type of the storage battery.

12. The model generation apparatus according to any one of claims 8 to 11, wherein
the measurement data for training and the measurement data for calculation each includes current, voltage, and temperature.

13. The model generation apparatus according to claim 12, wherein
the measurement data for training and the measurement data for calculation each consists of current, voltage, and temperature.

14. A model generation apparatus comprising:
a training data acquisition unit that acquires training data prepared for each different β, the training data using, as an input value, measurement data for training indicating a result of measuring a state of a storage battery when the number of charge and discharge times is αᵢ, and using, as a target value, SOH indicating a deterioration state of the storage battery when the number of charge and discharge times is β (where β > αᵢ); and
a model generation unit that generates, for each of a plurality of βs, a model for calculating an estimated value of SOH of a target storage battery when the number of charge and discharge times is β, from measurement data for calculation indicating the state when the number of charge and discharge times of the target storage battery is αᵢ, by performing machine-learning on the training data for each value of β.

15. A deterioration estimation method comprising:
causing a computer to execute:
a storage process of storing, in a storage unit, a plurality of models generated by performing machine-learning on training data, the training data using, as input values, measurement data for training indicating a result of measuring a state of a storage battery when the number of charge and discharge times is αᵢ to αⱼ (where j ≥ i), and using, as a target value, SOH indicating a deterioration state of the storage battery when the number of charge and discharge times is β (where β > αⱼ); and
a calculation process of acquiring measurement data for calculation that is a result of measuring the state when the number of charge and discharge times of a target storage battery to be processed is αᵢ to αⱼ, and inputting the measurement data for calculation into each of the plurality of models to calculate an estimation result of transition of SOH of the target storage battery, wherein
αᵢ and αⱼ are the same values in the plurality of models, and β is different in the plurality of models.

16. A deterioration estimation method comprising:
causing a computer to execute:
a storage process of storing, in a storage unit, a plurality of models generated by performing machine-learning on training data using, as an input value, measurement data for training indicating a result of measuring a state of a storage battery when the number of charge and discharge times is αᵢ, and using, as a target value, SOH indicating a deterioration state of the storage battery when the number of charge and discharge times is β (where β > αᵢ); and
a calculation process of acquiring measurement data for calculation that is a result of measuring the state when the number of charge and discharge times of a target storage battery to be processed is αᵢ, and inputting the measurement data for calculation into each of the plurality of models to calculate an estimation result of transition of SOH of the target storage battery, wherein
αᵢ is the same value in the plurality of models, and β is different in the plurality of models.

17. A model generation method comprising:
causing a computer to execute:
a training data acquisition process of acquiring training data prepared for each different β, the training data using, as input values, measurement data for training indicating a result of measuring a state of a storage battery when the number of charge and discharge times is αᵢ to αⱼ (where j ≥ i), and using, as a target value, SOH indicating a deterioration state of the storage battery when the number of charge and discharge times is β (where β > αⱼ); and
a model generation process of generating, for each of a plurality of βs, a model for calculating an estimated value of SOH of a target storage battery when the number of charge and discharge times is β, from measurement data for calculation indicating the state when the number of charge and discharge times of the target storage battery is αᵢ to αⱼ, by performing machine-learning on the training data for each value of β.

18. A model generation method comprising:
causing a computer to execute:
a training data acquisition process of acquiring training data prepared for each different β, the training data using, as an input value, measurement data for training indicating a result of measuring a state of a storage battery when the number of charge and discharge times is αᵢ, and using, as a target value, SOH indicating a deterioration state of the storage battery when the number of charge and discharge times is β (where β > αᵢ); and
a model generation process of generating, for each of a plurality of βs, a model for calculating an estimated value of SOH of a target storage battery when the number of charge and discharge times is β, from measurement data for calculation indicating the state when the number of charge and discharge times of the target storage battery is αᵢ, by performing machine-learning on the training data for each value of β.

19. A program causing a computer to have:
a storage process function for storing, in a storage unit, a plurality of models generated by performing machine-learning on training data, the training data using, an input values, measurement data for training indicating a result of measuring a state of a storage battery when the number of charge and discharge times is αᵢ to αⱼ (where j ≥ i), and using, as a target value, SOH indicating a deterioration state of the storage battery when the number of charge and discharge times is β (where β > αⱼ); and
a calculation process function for acquiring measurement data for calculation that is a result of measuring the state when the number of charge and discharge times of a target storage battery to be processed is αᵢ to αⱼ, and inputting the measurement data for calculation into each of the plurality of models to calculate an estimation result of transition of SOH of the target storage battery, wherein
αᵢ and αⱼ are the same values in the plurality of models, and β is different in the plurality of models.

20. A program causing a computer to have:
a storage process function for storing, in a storage unit, a plurality of models generated by performing machine-learning on training data, the training data using, as an input value, measurement data for training indicating a result of measuring a state of a storage battery when the number of charge and discharge times is αᵢ, and using, as a target value, SOH indicating a deterioration state of the storage battery when the number of charge and discharge times is β (where β > αᵢ); and
a calculation process function for acquiring measurement data for calculation that is a result of measuring the state when the number of charge and discharge times of a target storage battery to be processed is αᵢ, and inputting the measurement data for calculation into each of the plurality of models to calculate an estimation result of transition of SOH of the target storage battery, wherein
αᵢ is the same value in the plurality of models, and β is different in the plurality of models.

21. A program causing a computer to have:
a training data acquisition function for acquiring training data prepared for each different β, the training data using, as input values, measurement data for training indicating a result of measuring a state of a storage battery when the number of charge and discharge times is αᵢ to αⱼ (where j ≥ i), and using, as a target value, SOH indicating a deterioration state of the storage battery when the number of charge and discharge times is β (where β > αⱼ); and
a model generation function for generating, for each of a plurality of βs, a model for calculating an estimated value of SOH of a target storage battery when the number of charge and discharge times is β, from measurement data for calculation indicating the state when the number of charge and discharge times of the target storage battery is αᵢ to αⱼ, by performing machine-learning on the training data for each value of β.

22. A program causing a computer to have:
a training data acquisition function for acquiring training data prepared for each different β, the training data using, as an input value, measurement data for training indicating a result of measuring a state of a storage battery when the number of charge and discharge times is αᵢ, and using, as a target value, SOH indicating a deterioration state of the storage battery when the number of charge and discharge times is β (where β > αᵢ); and
a model generation function for generating, for each of a plurality of βs, a model for calculating an estimated value of SOH of a target storage battery when the number of charge and discharge times is β, from measurement data for calculation indicating the state when the number of charge and discharge times of the target storage battery is αᵢ, by machine-learning the training data for each value of β.
